# EUROPEAN PATENT APPLICATION

(11) **EP 1 962 346 A2**
(43) Date of publication of application: **27.08.2008**
(21) Application number: 08151693.2
(22) Date of filing: 20.02.2008
(51) Int. Cl.: H01L 27/146

(54) **Photoelectric conversion device and method of manufacturing the same**

(30) Priority: 23.02.2007 JP 2007044009
(71) Applicant: Canon Kabushiki Kaisha, Ohta-Ku, Tokyo 146-8501 (JP)
(72) Inventor: Mishima, Ryuichi, Tokyo Tokyo 146-8501 (JP); Naruse, Hiroaki, Tokyo Tokyo 146-8501 (JP)
(74) Representative: TBK-Patent

(57) **Abstract**

A photoelectric conversion device comprises a photoelectric conversion element disposed at a semiconductor substrate, and a multilayered wiring structure including a plurality of wiring layers disposed over the semiconductor substrate in such a manner to sandwich an interlayer insulation film therebetween. A diffusion suppressing film is disposed at least on the uppermost one of the wiring layers, the diffusion suppressing film serving to suppress diffusion of material forming the uppermost wiring layer; the diffusion suppressing film covers regions of the uppermost wiring layer and the interlayer insulation film corresponding to the photoelectric conversion element; and a lens is disposed with respect to a region of the diffusion suppressing film corresponding to the photoelectric conversion element.

## Description

### BACKGROUND OF THE INVENTION

### Field of the Invention

The present invention relates to a photoelectric conversion device and a method of manufacturing such a photoelectric conversion device, and more particularly to a photoelectric conversion device including a diffusion suppressing film for suppressing diffusion into interlayer insulation film of wiring material, and a method of manufacturing such a photoelectric conversion device.

### Description of the Related Art

In recent years, MOS type photoelectric conversion devices using MOS transistors have been extensively developed. In such photoelectric conversion devices, realization of reduction in size of pixel followed by realization of a large number of pixels is being developed. Following this trend, employment of an approach to change wiring material from aluminum to copper is being studied.

As a related art photoelectric conversion device using copper wiring, there is proposed such a structure as disclosed in the Patent Literature 1 (Japanese Patent Application Laid-Open No. 2005-311015). In the case where copper wiring is used in general semiconductor device, since diffusion coefficient in an oxide film generally used as an interlayer insulation film is large, it is necessary to dispose a diffusion suppressing layer for suppressing diffusion of copper. As a diffusion suppressing film of the upper layer of the copper wiring, SiN film is used in many cases. Moreover, in the case where diffusion coefficient in the interlayer insulation film of wiring material is large, it is necessary to use SiN film without being limited to the case of copper.

However, in the case where the diffusion suppressing film is used in the photoelectric conversion device, there results a multilayered structure of interlayer insulation film and diffusion suppressing film. By the influence based on reflection or multi-interference at the interface between the interlayer insulation film and the diffusion suppressing film resulting from such multilayered structure, lowering of quantity of light incident on the photoelectric conversion element takes place. For this reason, in the Patent Literature 1, the diffusion suppressing film in the region corresponding to the photoelectric conversion element is removed.

By removing the diffusion suppressing film, lowering of incident light quantity by the influence of reflection or multiple-interference at the interface between the interlayer insulation film and the diffusion suppressing film is reduced. However, processes such as photolithography and etching for removing the diffusion suppressing film on a light receiving unit are increased. Further, there are many cases where etching is performed under the plasma atmosphere. In such a case, there are instances where etching damage with respect to the photoelectric conversion element may lead to lowering of the characteristic of the photoelectric conversion device.

Further, in the case where the region corresponding to the photoelectric conversion element of the diffusion suppressing film is removed as described in the Patent Literature 1, it becomes difficult to maintain coplanarity. Thus, in the case where a lens is disposed within the region corresponding to the photoelectric conversion element, or in the case where a color filter is disposed, the formation surface is required to be flat. There further takes place a necessity of forming interlayer insulation film or planarized film. In the case where such films are laminated, the total film thickness from the light receiving unit is increased so that lowering of incident light quantity is feared. Such a fear is not only limited to the diffusion suppressing film on the uppermost wiring, but also similarly takes place with respect to diffusion suppressing film of lower wiring layer relative thereto. Particularly, in the case of the uppermost wiring layer, its influence is large.

In view of the above problems, an object of the present invention is to provide a suitable light converging structure such that also in the case where diffusion suppressing film for suppressing diffusion of wiring material is provided, the total film thickness of the diffusion suppressing film and the interlayer insulation film is not increased.

Moreover, an object of the present invention is to provide a photoelectric conversion device capable of reducing lowering of incident light by a simple process also in the case where diffusion suppressing film is provided, and a method of manufacturing such a photoelectric conversion device.

### SUMMARY OF THE INVENTION

In order to attain the above-described objects, the photoelectric conversion device of the present invention is a photoelectric conversion device comprising: a photoelectric conversion element disposed at a semiconductor substrate; and a multilayered wiring structure including a plurality of wiring layers disposed over the semiconductor substrate in such a manner to sandwich an interlayer insulation film therebetween, wherein a diffusion suppressing film is disposed at least on the uppermost one of the wiring layers, the diffusion suppressing film serving to suppress a diffusion of a material forming the uppermost wiring layer, the diffusion suppressing film covers regions of the uppermost wiring layer and the interlayer insulation film corresponding to the photoelectric conversion element, and a lens is disposed with respect to a region of the diffusion suppressing film corresponding to the photoelectric conversion element such that the lens is formed from a part of the diffusion suppressing film disposed on the uppermost wiring layer, or is disposed in directly contact with the diffusion suppressing film disposed on the uppermost wiring layer.

Other features and advantages of the present invention will be apparent from the following description taken in conjunction with the accompanying drawings, in which like reference characters designate the same or similar parts throughout the figures thereof.

### BRIEF DESCRIPTION OF THE DRAWINGS

FIG. 1 is a cross sectional diagram of the periphery of a light receiving unit of a photoelectric conversion device according to a first exemplary embodiment of the present invention.

FIG. 2 is a cross sectional diagram for describing a method of manufacturing the photoelectric conversion device illustrated in FIG. 1.

FIG. 3 is a cross sectional diagram for describing the method of manufacturing the photoelectric conversion device illustrated in FIG. 1.

FIG. 4 is a cross sectional diagram for describing the method of manufacturing the photoelectric conversion device illustrated in FIG. 1.

FIG. 5 is a cross sectional diagram for describing the method of manufacturing the photoelectric conversion device illustrated in FIG. 1.

FIG. 6 is a cross sectional view of pixel region of a photoelectric conversion device according to a second exemplary embodiment of the present invention.

FIG. 7 is a cross sectional diagram for describing the method of manufacturing the photoelectric conversion device illustrated in FIG. 6.

FIG. 8 is a cross sectional diagram for describing the method of manufacturing the photoelectric conversion device illustrated in FIG. 6.

FIG. 9 is a cross sectional diagram for describing the method of manufacturing the photoelectric conversion device illustrated in FIG. 6.

FIG. 10 is a cross sectional view of a photoelectric conversion device of a third exemplary embodiment of the present invention.

FIG. 11 is a plane arrangement diagram of the photoelectric conversion device of the third exemplary embodiment of the present invention.

FIG. 12 is a cross sectional diagram of a photoelectric conversion device of a fourth exemplary embodiment of the present invention.

FIG. 13 is a cross sectional diagram of a modified example of the photoelectric conversion device of the fourth embodiment of the present invention.

The accompanying drawings, which are incorporated in and constitute a part of the specification, illustrate embodiments of the invention and, together with the description, serve to explain the principles of the invention.

### DESCRIPTION OF THE EMBODIMENTS

Desired exemplary embodiments of the present invention will now be described in detail with reference to the attached drawings.

(First exemplary embodiment)

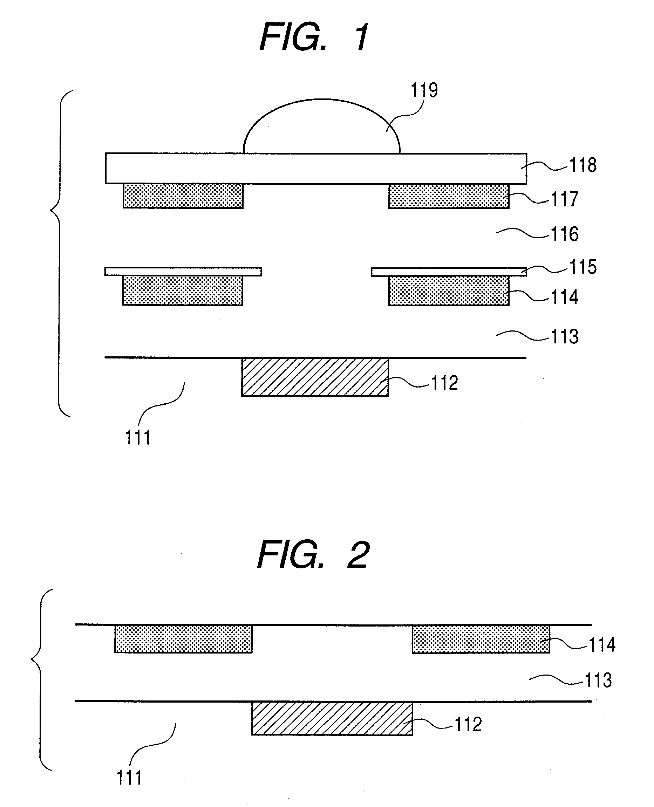

FIG. 1 illustrates a cross sectional structure of a photoelectric conversion device in the first exemplary embodiment of the present invention. It is to be noted that, in the description of the detailed configuration of the present embodiment and respective figures, description of element regions and element isolation areas, etc. formed on a semiconductor substrate will be omitted for simplifying the description.

At a semiconductor substrate 111, there are arranged plural photodiodes 112 each functioning as a photoelectric conversion element for performing photoelectric conversion. The region where such photoelectric conversion element is disposed is called a pixel region. Further, a multilayered wiring structure including wiring layers 114, 117 buried in interlayer insulation films which will be described later is disposed over the semiconductor substrate 111.

On the upper surface of the semiconductor substrate, there is disposed a first interlayer insulation film 113. As the first interlayer insulation film 113, there may be used silicon oxide film. The first wiring layer 114 is embedded in the first interlayer insulation film. This first wiring layer 114 is formed by forming a trench at the first interlayer insulation film 113 to bury conductor such as copper into this trench to remove conductor except for the trench part by the CMP process (damascene process).

Further, there is disposed a first diffusion suppressing film 115 for covering the first wiring layer, and for suppressing diffusion of material forming the first wiring. As the diffusion suppressing film, there may be used silicon nitride film or silicon carbide film. This first diffusion suppressing film 115 is configured so that the film body is selectively removed in the region corresponding to the photoelectric conversion element, and reflection of incident light at the interface between the interlayer insulation film and the diffusion suppressing film is thus reduced.

Further, a second interlayer insulation film 116 containing silicon oxide film is disposed on the first diffusion suppressing film 115. In addition, a second wiring layer 117 serving as the uppermost wiring layer is buried in the second interlayer insulation film 116 as a wiring layer disposed in the pixel region. This second wiring layer may be also formed by formation process similar to that of the first wiring layer.

A silicon nitride film 118 is disposed on the upper part of the second wiring layer 117 as the second diffusion suppressing film. Further, inner-layer lenses 119 corresponding to each photoelectric conversion element is disposed in a region corresponding to the photoelectric conversion element on the second diffusion suppressing film. In addition, the silicon nitride film also functions as the second diffusion suppressing film and a protective film.

In the photoelectric conversion device of the present embodiment, diffusion suppressing film disposed on the uppermost wiring layer of the multilayered wiring structure is disposed also within a region corresponding to the photoelectric conversion element, and the lens utilizing the diffusion suppressing film is disposed. Alternatively, the lens may be disposed in the state directly in contact with the diffusion suppressing film by a layer different from the diffusion suppressing film. Since the diffusion suppressing film is disposed in a manner to cover a region corresponding to the photoelectric conversion element of the interlayer insulation film, an offset resulting from the fact that the diffusion suppressing film is removed does not takes place. As a result, a lens of such a configuration can be formed.

Thus, a process step of removing only the region corresponding to the photoelectric conversion element region of the diffusion suppressing film, and a process step of forming an interlayer insulation film further disposed on the upper layer thereof can be omitted. Here, the region corresponding to the photoelectric conversion element is a region corresponding to an optical path when light is incident on the photoelectric conversion device. Accordingly, the part which is not light-shielded by light shielding member corresponds to this region within the pixel region. By disposing a lens, incidence efficiency onto light receiving unit (photoelectric conversion element) can be enhanced.

A method of manufacturing the photoelectric conversion device in the present embodiment will now be described. The structure in which copper is used as wiring material and wire is buried in the interlayer insulation film will be described.

First, plural semiconductor regions each functioning as electrode region of photoelectric conversion element 112 and transistor (not shown), and element isolation regions for isolating elements therebetween are formed over the semiconductor substrate.

Further, polysilicon (not shown) serving as gate electrode of transistor is formed on the semiconductor substrate, and silicon oxide film is deposited by the CVD process (Chemical Vapor Deposition) process. Thereafter, planarization is implemented by the CMP process (Chemical-Mechanical Polishing) process to thereby form first interlayer insulation film 113.

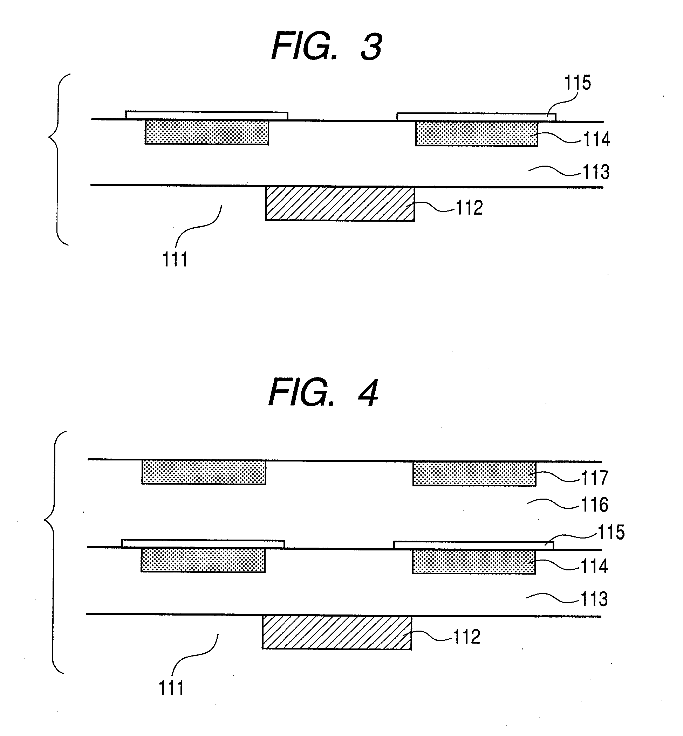

Next, first copper wires 114 are buried into the first interlayer insulation film by the damascene process (FIG. 2). Thereafter, first diffusion suppressing film 115 is formed on the entire surface by silicon nitride film thereafter to remove the diffusion suppressing film 115 disposed in the region corresponding to the photoelectric conversion element by the lithography technology and the dry etching technology (FIG. 3). However, in the case where refractive index difference between the diffusion suppressing film 115 and the interlayer insulation film is not so large, the diffusion suppressing film 115 may be left as it is.

Next, silicon oxide film is formed by the CVD process to form a second interlayer insulation film 116. In the case where there is a desire to reduce the influence of an offset of the first diffusion suppressing film in formation of the second interlayer insulation film, the second interlayer insulation film may be planarized by the CPM process.

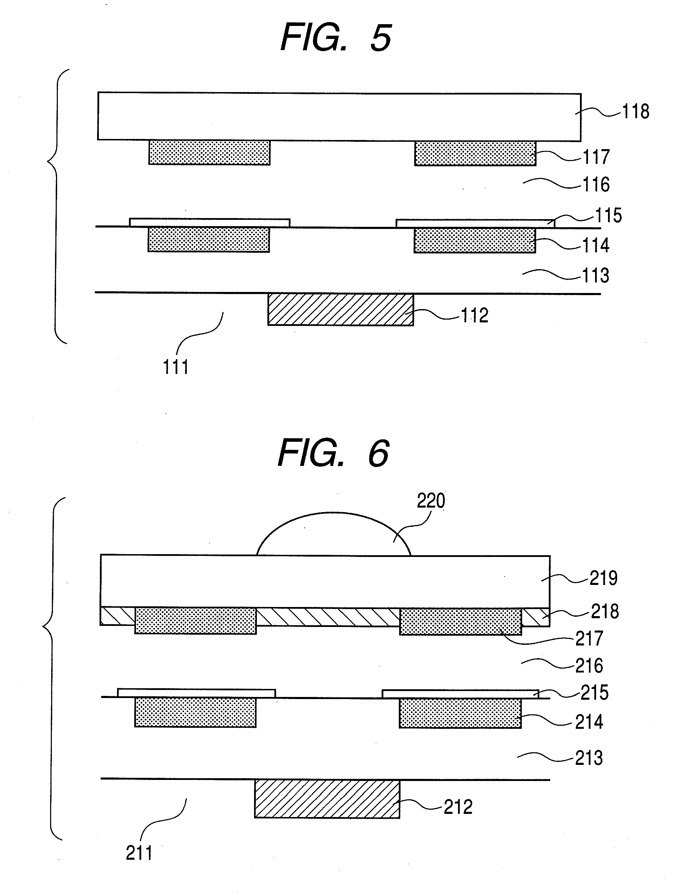

Next, second wiring layer 117 serving as the uppermost wiring layer is formed by the damascene process within the pixel region (FIG. 4). Further, silicon nitride film 118 functioning as a second diffusion suppressing film is formed by the CVD process. Since the second diffusion suppressing film is caused to function also as a protective film, the film thickness thereof is caused to be thicker than that of the first diffusion suppressing film to enhance protective function (FIG. 5). Moreover, in order to enhance the protective characteristic, it is desirable to dispose the second diffusion suppressing film in a manner to cover the entire surface including an area corresponding to the photoelectric conversion element.

Thereafter, inner-layer lens 119 is formed by using the lithography technology and the dry etching technology within a region corresponding to the photoelectric conversion element to thereby form the photoelectric conversion device of the present embodiment.

It is to be noted that although omitted in the present embodiment, a reflection prevention film may be used between the first interlayer insulation film 113 and the semiconductor substrate 111 in order to reduce reflection of incident light at the interface between the interlayer insulation film and the semiconductor substrate. As the reflection prevention film, there may be used, e.g., silicon nitride film. Further, in formation of copper wiring, such copper wiring may be formed by using either one of the single-damascene process, and the dual-damascene process, and the number of wiring layers is not limited to two.

Moreover, while a convex lens is formed as the inner-layer lens 119, a concave lens may be used. Further, as a method of forming lens, a silicon nitride film serving as a second diffusion suppressing film is thickly formed thereafter to transfer a resist pattern caused to have a lens shape with respect to the silicon nitride film. Thus, a portion of the silicon nitride film may be caused to have a lens shape. In this way, the process step can be further shortened. Moreover, the present embodiment may be similarly applied to the structure in which color filter or micro lens is provided as occasion demands on the upper part of the inner-layer lens. Since the second diffusion suppressing film is not removed within the region corresponding to the photoelectric conversion element also in such a configuration, these members may be disposed without separately providing the interlayer insulation film or the planarized film. Thus, the height of the device can be reduced. Further, since the second diffusion suppressing film is disposed in a manner to cover the region corresponding to the photoelectric conversion element, the structure doubling as a protective film and a diffusion suppressing film can be provided. Thus, a process step of allowing the diffusion suppressing film to undergo patterning can be eliminated while maintaining the function as a protective layer.

(Second embodiment)

FIG. 6 is a cross sectional structural diagram of a photoelectric conversion device in the second exemplary embodiment of the present invention. The present embodiment is a modified embodiment of the first embodiment. At an interface between interlayer insulation film (silicon oxide film) in which the uppermost wiring layer is buried and a diffusion suppressing film (silicon nitride film) disposed at the upper part thereof, there is disposed a reflection prevention film (silicon oxynitride film). The silicon oxynitride film serves to suppress reflection of an incident light at the interface between the silicon oxide film 216 and the silicon nitride film 219. Accordingly, the reflection prevention film is not limited to silicon oxynitride film, but any material to reduce reflection at the interface may be employed.

A manufacturing method of the present embodiment will be described. The process steps of first forming first wiring layer 214, and subsequently forming first diffusion suppressing film 215 are similar to those of the first embodiment.

Thereafter, silicon oxide film 216 is formed by the CVD process. In the case where there is a desire to reduce the influence of offset of the first diffusion suppressing film 215, planarization is performed by the CMP process.

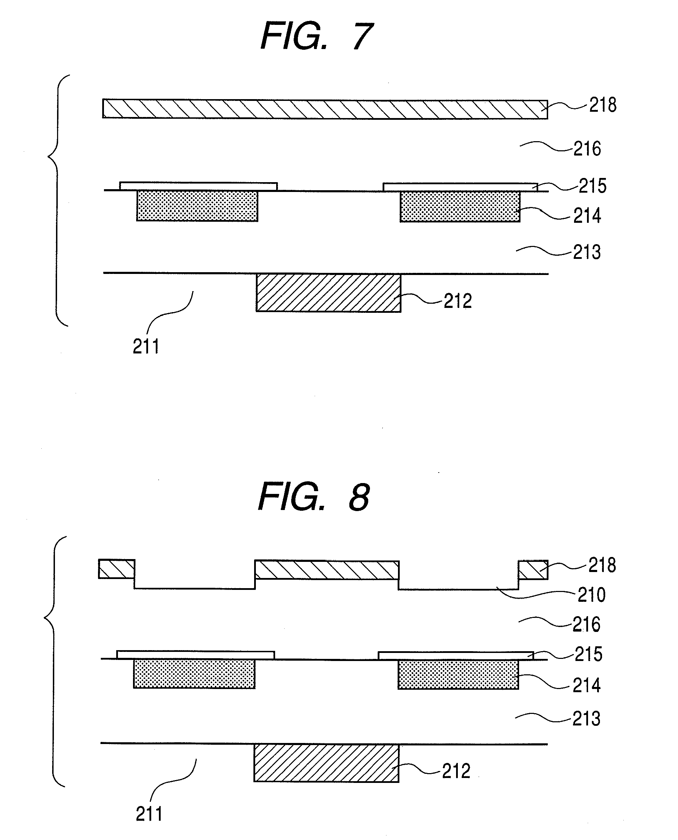

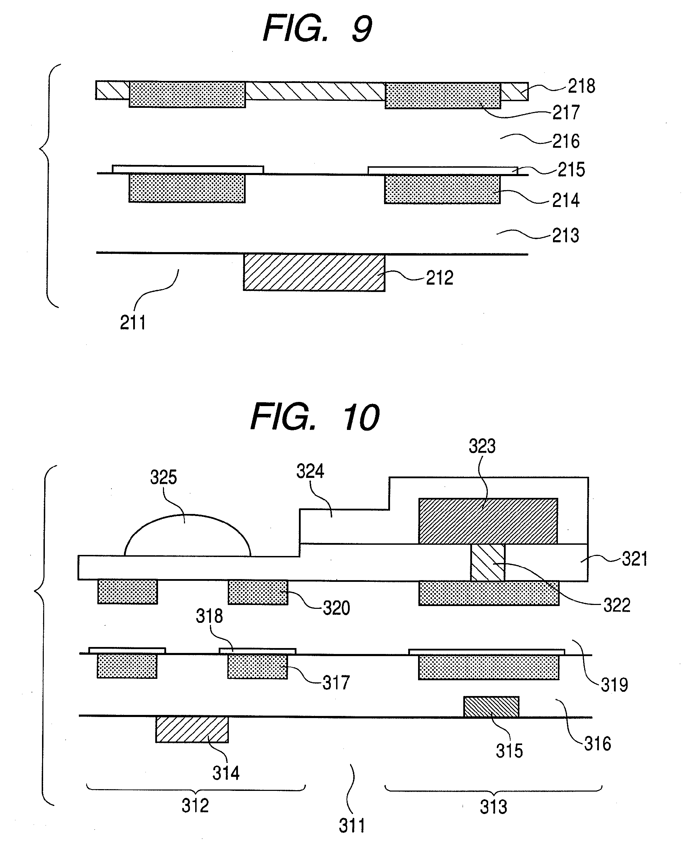

Further, a silicon oxynitride film 218 is formed on the silicon oxide film 216 (interlayer insulation film) by the CVD process (FIG. 7). Thus, double-layer structure (laminated structure) of the silicon oxide film 216 and the silicon oxynitride film 218 is formed. Namely, reflection prevention film to reduce reflection of an incident light at the interface between the interlayer insulation film and the diffusion suppressing film is formed on the interlayer insulation film. Thus, a laminated structure of the interlayer insulation film and the reflection preventing film is formed. Thereafter, etching is performed with respect to the region where wires are disposed of the double layer structure. Thus, wiring trenches 210 are formed (FIG. 8). At this time, at the same time, via hole portions may be also formed by etching (dual damascene). Moreover, copper is formed at the wiring trenches 210 and via holes by plating to remove copper except for the trench 210 portions by the CMP process to thereby second wiring layer 217 (FIG. 9). Further, there is formed a silicon nitride film 219 functioning as protective film and diffusion preventing film for material of the second wiring layer. Furthermore, an inner-layer lens 220 is formed within the region corresponding to the photoelectric conversion element on the silicon nitride film 219. Thus, photoelectric conversion device of FIG. 6 is provided.

In the present embodiment, reflection prevention film 218 by silicon oxynitride film is disposed between the silicon oxide film forming the second interlayer insulation film 216 and the silicon nitride film 219 on the second wiring layer 217. Thus, reflection on the interface between the silicon oxide film 216 and the silicon nitride film 219 is suppressed. As a result, loss of light can be further reduced.

In addition, in accordance with the manufacturing method of the present embodiment, in a process step of forming double-layer structure of silicon oxide film 216 and silicon oxynitride film 218 thereafter to form wiring trench, the reflection prevention film is also etched simultaneously with the silicon oxide film. Thus, the process steps can be shortened. As a result, reflection preventing film can be formed within the entire of the region where wiring layer including a region corresponding to the light receiving unit of the photoelectric conversion element is not disposed (the region where no wiring trench is formed).

(Third embodiment)

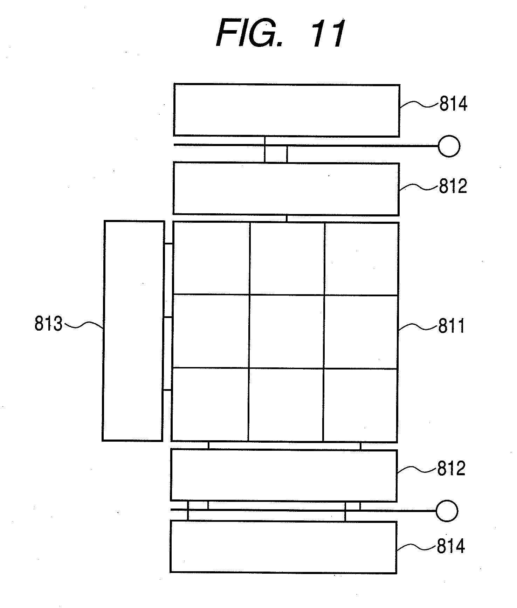

FIGS. 10 and 11 are respectively a cross sectional diagram and a plane arrangement diagram of a photoelectric conversion device of a third exemplary embodiment of the present invention. The plane arrangement diagram of FIG. 11 will be first described.

The photoelectric conversion device of the present embodiment includes a photoelectric conversion area 811. A unit of a signal which is read out from a single photoelectric conversion elements is caused to be a pixel, and the region where the photoelectric conversion element is disposed can be also called a pixel region. The pixel is the minimum unit of single photoelectric conversion element and element set for reading out a signal from the photoelectric conversion element to an output line. Within this element set, there are included a transfer unit such as transfer MOS transistor, amplifier unit such as amplifier MOS transistor, and a reset unit such as reset MOS transistor. While, in adjacent photoelectric elements, those elements may be shared, the pixel is defined by the minimum unit of element set for reading out a signal of single photoelectric conversion element also in this case.

The photoelectric conversion device further includes a signal processing circuit 812 for amplifying a signal which has been read out from the photoelectric conversion region. It is to be noted that the signal processing circuit 812 is not limited to the amplifier circuit, but may be a circuit for removing noise of pixel by CDS processing. Moreover, the signal processing circuit 812 may be a circuit for merely converting signals which are read out in parallel from plural train into a serial signal. The photoelectric conversion device further includes a vertical shift register 813 for driving MOS transistors disposed within the pixel area, and a horizontal shift register 814 for driving MOS transistors of the signal processing circuit. The circuit components 812 to 814 may be included within the peripheral circuit. The region where these circuit components are disposed is called a peripheral circuit region. Generally speaking, it can be said that these peripheral circuits serve to control a signal output from the photoelectric conversion element. In addition, in the case where AD conversion is performed in the photoelectric conversion device, an AD conversion circuit may be included therewithin. The pixel region 811 and the peripheral circuits 812 to 814 are disposed over the same semiconductor substrate.

Description will now be made with reference to FIG. 10. On a semiconductor substrate 311, there is disposed a pixel region 312 where plural photodiodes 314 each functioning as a photoelectric conversion element are disposed in an array form. This pixel area 312 is a region corresponding to the pixel region 811 in FIG. 11.

Moreover, a peripheral circuit 313 is also disposed on the same substrate. This peripheral circuit 313 corresponds to any one or all of the peripheral circuits 812 to 814 in FIG. 11. The number of wiring layers of the pixel region is larger than the number of wiring layers of the peripheral circuit region.

A method of manufacturing the photoelectric conversion device of the present embodiment will be described. Since the process steps up to formation of the second wiring layer 320 serving as the uppermost wiring layer of the pixel region may be implemented by using process steps of the first embodiment, etc., their description will be omitted.

After the second wiring layer 320 is formed, there is formed a silicon nitride film 321 serving to cover the second wiring layer 320 and functioning as a diffusion suppressing film. In the peripheral circuit region 313, this first silicon nitride film 321 is caused to function as an interlayer insulation film. A first via plug 322 is formed at the first silicon nitride film 321 to further form a third wiring layer 323 within the peripheral circuit region 313. As wiring material of the third wiring layer, it is desirable to use aluminum. The reason why aluminum is used is that bonding pad for electrically connecting to the external is formed by way of the third wiring layer, and connection between bonding pad and wiring for taking electrical connection to the external device is thus easy as compared to copper.

Further, a protective film containing the second silicon nitride film 324 is formed on the third wiring layer 323.

Accordingly, the pixel region is caused to be of the structure in which first silicon nitride film 321 and second silicon nitride film 324 are laminated. In addition, an inner-layer lens 325 is formed by the above-described transfer etching with respect to the laminated structure of the silicon nitride film.

In the photoelectric conversion device in the present embodiment, the silicon nitride film on the uppermost wiring layer of the pixel region is caused to double as a diffusion suppressing film and an interlayer insulation film of the peripheral circuit region. Also in the present embodiment, the process step of removing only the area corresponding to the photoelectric conversion element of the diffusion suppressing film can be omitted. As a result, it also becomes unnecessary to form interlayer insulation film necessary when the diffusion suppressing film has been removed. For this reason, the total film thickness on the photoelectric conversion element of the pixel region can be reduced. Further, by forming the inner-layer lens, incidence efficiency onto the light receiving unit can be enhanced.

Further, since the interlayer insulation film disposed between the second and third wiring layers serve as a silicon nitride film single layer within the peripheral circuit region, formation of via contact becomes easy.

A method of manufacturing the photoelectric conversion device in the present embodiment will now be described.

On the semiconductor substrate 311, there are formed pixel region 312 where photoelectric conversion elements are disposed in an array form, and peripheral circuit region 313. It is sufficient that photoelectric conversion element and transistor forming the peripheral circuit may be formed by the same process as that of the related art. The first interlayer insulation film 316 is formed by depositing silicon oxide film by, e.g., the CVD process thereafter to planarize the silicon oxide film by the CMP process.

Next, first wiring layer 317 is buried at the first interlayer insulation film 316 by the damascene process. Further, the first diffusion suppressing film 318 is formed on the entire surface thereafter to remove the part on the light receiving unit by the lithography technology and the dry etching technology, etc.

The first diffusion suppressing film 318 of the peripheral circuit region may be formed over the entire surface of the peripheral circuit region. Further, the second interlayer insulation film 319 containing silicon oxide film is formed by, e.g., the CVD process. In formation of the second interlayer insulation film 319, in the case where there is a desire to suppress the influence of an offset of the first diffusion suppressing film 318, the second interlayer insulation film 319 may be planarized by the CMP process.

Next, the second wiring layer 320 serving as the uppermost wiring layer within the pixel area is formed by the damascene process. Next, first silicon nitride film 321 functioning as diffusion suppressing film and third interlayer insulation film are formed by the CVD process. Thereafter, first via plug is formed at silicon nitride film 321 within the peripheral circuit region. Thereafter, third wiring layer 323 is formed thereafter to form second silicon nitride film 324 onto the entirety of the pixel region and the peripheral circuit area.

Thereafter, the first and second silicon nitride films 321 and 324 which are laminated within the pixel region are used to form inner-layer lens 325 within a region corresponding to the photoelectric conversion element to thereby form a photoelectric conversion device in the present embodiment.

In the present embodiment, the pixel region includes wiring layers of two layers, and the peripheral circuit region includes wiring layers of three layers. The number of wiring layers in the peripheral circuit region is larger than that in the pixel region. Further, the peripheral circuit region is configured so as to include copper wiring layers of double layers and aluminum wiring layer of single layer. Moreover, the number of wiring layers of the pixel region is not limited to be two. Further, in the peripheral circuit part, wiring material of the upper layer relative to the wiring layer disposed in the pixel region is not limited to aluminum. In the peripheral circuit region, plural copper wirings may be formed through an intermediate insulation film formed by silicon nitride film on the upper layer relative to the uppermost wiring layer of the pixel area.

(Fourth embodiment)

In the above-mentioned first to third embodiments, the diffusion suppressing film disposed on the uppermost wiring layer of the pixel region has been described. In the fourth embodiment, the wiring layer except for the uppermost wiring layer of the multilayered wiring structure and its diffusion suppressing film will be described.

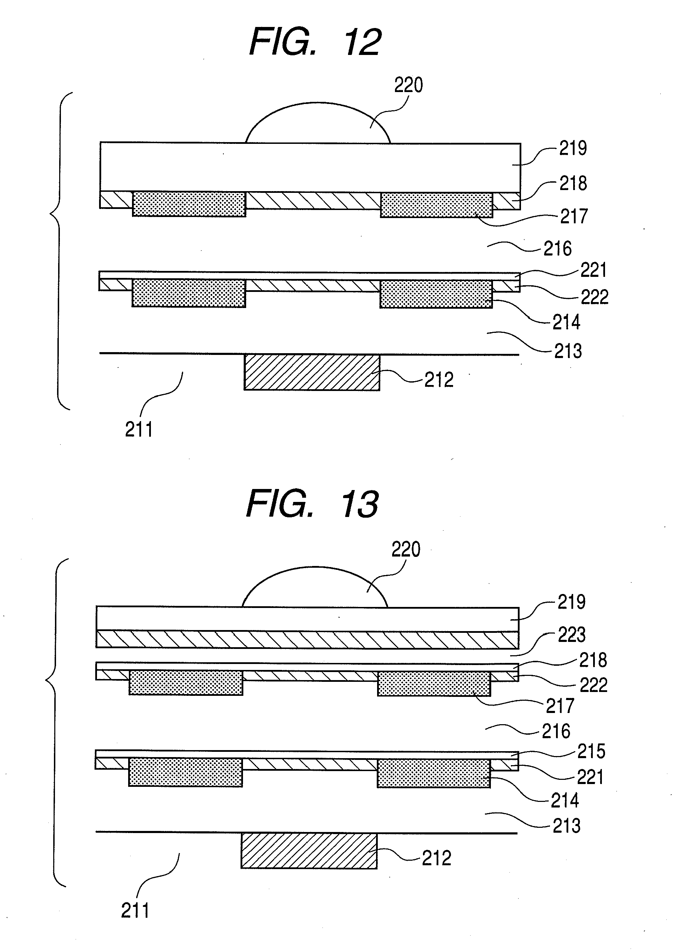

FIG. 12 illustrates a cross sectional diagram of a photoelectric conversion device of the fourth embodiment of the present invention. In the present embodiment, there is employed a structure in which reflection prevention film is provided, with respect to the configuration of the second embodiment, between diffusion suppressing film of wiring layer (e.g., first wiring layer) except for the uppermost wiring layer of the pixel region, and interlayer insulation film with which the diffusion suppressing film is in contact. Further, there is employed a configuration in which this diffusion suppressing film is left without undergoing patterning also in the region corresponding to the photoelectric conversion element. In accordance with such a configuration, a process step of performing patterning of the first diffusion suppressing film can be eliminated. Thus, facilitation of process can be realized. In addition, there is no possibility that etching damage in etching the first diffusion suppressing film may be given to the photoelectric conversion element. The photoelectric conversion element of the present embodiment will be described with reference to FIG. 12. Similar reference numerals are respectively attached to components similar to those of FIG. 6, and their detailed description will be omitted.

In FIG. 12, a first diffusion suppressing film 221 disposed on first wiring layer 214 is disposed in a manner to cover the entirety of the underlying film. Namely, there is employed a configuration in which first the diffusion suppressing film 221 is disposed also within a region corresponding to the photoelectric conversion element. Further, a reflection prevention film 222 is disposed within the region corresponding to the photoelectric conversion element 212 of the lower part of the first diffusion suppressing film 221. The reflection prevention film 222 may be formed by the same process as that of the second embodiment.

In accordance with the present embodiment, since it also becomes unnecessary to perform patterning of the first diffusion suppressing film, facilitation of process can be realized. Moreover, since etching process for patterning of the first diffusion suppressing film can be eliminated at the same time, etching damage with respect to the photoelectric conversion device can be also eliminated.

In addition, a modified example of the present embodiment is illustrated in FIG. 13. The modified example differs from the fourth embodiment in that diffusion suppressing film 218 on the uppermost wiring layer of the pixel region and protective film 219 are formed by different constituent members.

It is to be noted that the present invention is not limited to these exemplary embodiments, but plural exemplary embodiments may be combined as occasion demands. Moreover, the damascene process for burying wires into the interlayer insulation film has been described as the wiring formation process, but the wiring formation process is not limited to such damascene process. In the case where material having large diffusion coefficient, which is diffused within the interlayer insulation film, such as, for example, copper is used as wiring material, any photoelectric conversion device using diffusion suppressing material may be applied. In addition, wiring material is not limited to copper, but the present invention can be applied to the configuration using wiring material in which diffusion within the interlayer insulation film becomes problem.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions. A photoelectric conversion device comprises a photoelectric conversion element disposed at a semiconductor substrate, and a multilayered wiring structure including a plurality of wiring layers disposed over the semiconductor substrate in such a manner to sandwich an interlayer insulation film therebetween. A diffusion suppressing film is disposed at least on the uppermost one of the wiring layers, the diffusion suppressing film serving to suppress diffusion of material forming the uppermost wiring layer; the diffusion suppressing film covers regions of the uppermost wiring layer and the interlayer insulation film corresponding to the photoelectric conversion element; and a lens is disposed with respect to a region of the diffusion suppressing film corresponding to the photoelectric conversion element.

## Claims

1. A photoelectric conversion device comprising:
a photoelectric conversion element disposed on a semiconductor substrate; and
a multilayered wiring structure including a plurality of wiring layers disposed to sandwich an interlayer insulation film therebetween over the semiconductor substrate,
a diffusion suppressing film is disposed on an uppermost wiring layer among the wiring layers to suppress a diffusion of a material forming the uppermost wiring layer,
the diffusion suppressing film covers regions of the uppermost wiring layer and the interlayer insulation film corresponding to the photoelectric conversion element,
a lens is disposed at a region corresponding to the photoelectric conversion element, and is formed from a part of the diffusion suppressing film disposed on the uppermost wiring layer, or is disposed in directly contact with the diffusion suppressing film.

2. The photoelectric conversion device according to claim 1, wherein
the wiring layer is formed from Cu.

3. The photoelectric conversion device according to claim 1, wherein
at least one of the wiring layers forms a damascene structure.

4. The photoelectric conversion device according to any one of claims 1 to 3, wherein
the diffusion suppressing film contains silicon nitride film.

5. The photoelectric conversion device according to claim 1, wherein
at an interface between the interlayer insulation film and the diffusion suppressing film, a reflection prevention film is disposed.

6. The photoelectric conversion device according to claim 5, wherein
the reflection prevention film contains silicon nitride film.

7. The photoelectric conversion device according to claim 1, further comprising a peripheral circuit disposed on the semiconductor substrate for controlling an output signal from the photoelectric conversion element, wherein a first part of the diffusion suppressing film is an interlayer insulation film disposed between different ones of the wiring layers in the peripheral circuit.

8. The photoelectric conversion device according to claim 7, wherein
the first part of the diffusion suppressing film operates also as a protective film.

9. A photoelectric conversion device comprising:
pixel region in which a plurality of photoelectric conversion elements are disposed; and
a peripheral circuit region in which a circuit for controlling an out put signal from the photoelectric conversion element, wherein
the pixel region and the peripheral circuit region are disposed on a common semiconductor substrate,
a multilayered wiring structure including a plurality of wiring layers disposed to sandwich an interlayer insulation film therebetween is disposed over the semiconductor substrate,
a number of the wiring layers of the pixel regions is larger than a number of the wiring layers of the peripheral circuit region,
a diffusion suppressing film is disposed on an uppermost wiring layer among the wiring layers of said pixel region to suppress a diffusion of a material forming the uppermost wiring layer, and
the diffusion suppressing film is an interlayer insulation film in the peripheral circuit region.

10. The photoelectric conversion device according to claim 9, wherein
a lens is disposed in a region of the diffusion suppressing film corresponding to the photoelectric conversion element.

11. The photoelectric conversion device according to claim 9, wherein
a lens is formed from a part of the diffusion suppressing film disposed on the uppermost wiring layer, or is disposed in directly contact with the diffusion suppressing film.

12. The photoelectric conversion device according to claim 9, wherein
the wiring layer is formed from Cu.

13. A method of manufacturing a photoelectric conversion device comprising:
a photoelectric conversion element disposed on a semiconductor substrate,
a multilayered wiring structure including a plurality of wiring layers buried in an interlayer insulation film over the semiconductor substrate, and
a diffusion suppressing film disposed on an uppermost wiring layer among the wiring layers to suppress diffusion of a material forming the uppermost wiring layer,
wherein the method comprising steps of:
forming the interlayer insulation film;
forming, on the interlayer insulation film, a reflection prevention film for reducing a reflection of a light incident into an interface between the interlayer insulation film and the diffusion suppressing film, so as to form a stacked structure of the interlayer insulation film and the reflection prevention film;
removing a part of the stacked structure in which the wiring is to be formed, so as to form a wiring trench; and
filling the wiring trench with a wiring material to form the wiring.
